(19) Europäisches Patentamt
European Patent Office
Office européen des brevets

(11) Veröffentlichungsnummer: **0 404 973 A1**

# (12) EUROPÄISCHE PATENTANMELDUNG

(21) Anmeldenummer: **89111705.3**

(22) Anmeldetag: **27.06.89**

(51) Int. Cl.5: **C23C 14/02**, C23C 14/42

(43) Veröffentlichungstag der Anmeldung:
**02.01.91 Patentblatt 91/01**

(84) Benannte Vertragsstaaten:
**AT BE CH DE ES FR GB IT LI LU NL SE**

(71) Anmelder: **HAUZER HOLDING B.V.**
**Groethofstraat 27**
**NL-5900 AE Venlo(NL)**

(72) Erfinder: **Wesemeyer, Harald, Dr.**
**Skattegard i Hanger**
**S-33194 Hanger - Varnamo(SE)**

(74) Vertreter: **Dipl.-Phys.Dr. Manitz**
**Dipl.-Ing.Dipl.-Wirtsch.-Ing. Finsterwald**
**Dipl.-Phys. Rotermund Dipl.-Chem.Dr. Heyn**
**B.Sc.(Phys.) Morgan**
**Robert-Koch-Strasse 1**
**D-8000 München 22(DE)**

## (54) Verfahren und Vorrichtung zur Beschichtung von Substraten.

(57) Es wird ein Verfahren sowie eine Vorrichtung zur Beschichtung von Substraten beschrieben, bei denen die aufzubringende Schicht durch auf das betreffende Substrat 34 auftreffende kondensierende Teilchen eines mittels einer Gasentladung erzeugten Plasmas hergestellt wird. Zur Verankerung der aufzubauenden Schicht sowie zur Herstellung einer Haftgrenzschicht wird zunächst eine Bogenentladungsverdampfung durchgeführt. Zur Herstellung einer hochqualitativen, sich an die Haftgrenzschicht anschließenden Schicht wird eine Kathodenzerstäubung vorgenommen. Für sämtliche Plasmastromkreise 18 bis 22 ist eine gemeinsame Elektrode 14 vorgesehen.

FIG.3

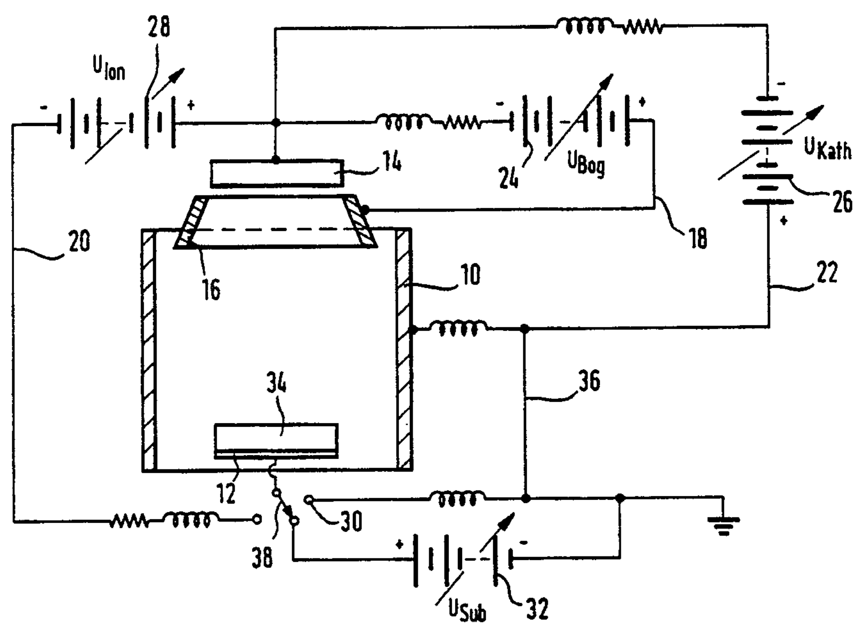


EP 0 404 973 A1

Die Erfindung betrifft ein Verfahren zur Beschichtung von Substraten, bei welchem die aufzubringende Schicht durch auf das betreffende Substrat auftreffende kondensierende Teilchen eines mittels einer Gasentladung erzeugten Plasmas hergestellt wird.

Die Erfindung betrifft ferner eine Vorrichtung zur Durchführung des Verfahrens.

Die Technik der Oberflächenbearbeitung und insbesondere die Herstellung dünner Schichten hat während der vergangenen Jahre auch in ihrer industriellen Anwendung große Bedeutung erlangt. Zu den zahlreichen bekannten Verfahren zur Herstellung oder Bearbeitung von dünnen Schichten bzw. zur Behandlung von Materialoberflächen zählen in erster Linie jene Verfahren, welche auf durch Joule'sche Wärme erzeugter Verdampfung in Öfen, Schiffchen, Tiegeln usw. beruhen und bei denen die Verdampfung insbesondere durch Stromwärme oder durch Elektronen- oder Ionenbeschuß erzeugt wird. Anderen Verfahren liegt die Verdampfung mittels eines anodischen oder kathodischen Lichtbogens oder auch eine Wirbelstromerhitzung von leitendem Material in einem induzierten Wechselstromfeld zugrunde. Zu erwähnen ist auch die großflächige Sublimation von Kathoden in den verschiedenen Ausführungsformen der Kathodenzerstäubung mit oder ohne magnetische Verstärkung der Ionisation in der Gleichstrom- oder Wechselstromglimmentladung.

Bei den bekannten und gebräuchlichen Verdampfungsverfahren sind die kinetischen Energien der auf das Substrat auftreffenden Atome und Ionen bzw. diese auf dem Substrat auftreffenden Teilchen derart verteilt, daß die hochenergetischen Teile mehr Zerstörung in der Art von Kristallzerspaltung, Kristallzerstörung oder einer Kathodenzerstäubung ähnlichem Zerfall einer Substratoberfläche bewirken als eine für ein fehlerfreies Kristallwachstum erforderliche gute, gleichmäßige Kondensation. Andererseits erreichen die auftreffenden Teilchen niedriger Energie oft kaum die notwendige Bewegungsenergie an der Oberfläche zum ordnungsgemäßen Einbau in ein Kristallgitter. Eine insoweit ungünstige sehr breite Verteilung der Bewegungsenergien der auf das Substrat auftreffenden Atome und Ionen leigt insbesondere beim Bogenverdampfungsverfahren vor.

Als nachteilig bei einer Beschichtung mittels einer Kathodenzerstäubung ist in erster Linie der Mangel an Energie der kondensierenden Teilchen anzusehen, was einer guten Haftung der aufwachsenden Schicht auf dem Substrat entgegensteht. In diesem Zusammenhang ist auch der Mangel an ionisierten Teilchen zu erwähnen, so daß die Energie der auftreffenden Teilchen selbst mittels einer Vorspannung am Substrat praktisch nicht erhöht werden kann.

Der Erfindung liegt die Aufgabe zugrunde, das Verfahren zur Beschichtung von Substraten der eingangs genannten Art derart weiterzubilden, daß bei einer feinfühligen Steuerbarkeit des Kristallwachstums sowie des Kristallgefüges der aufzubringenden Schicht diese dadurch mit hoher Qualität herstellbare Schicht gleichzeitig fest auf dem Substrat haftet.

Die Aufgabe wird nach der Erfindung dadurch gelöst, daß sowohl eine Bogenentladungsverdampfung als auch eine Kathodenzerstäubung vogenommen wird und daß die Bogenentladungsverdampfung vor der Kathodenzerstäubung durchgeführt wird.

Aufgrund der der Kathodenzerstäubung vorangehenden Bogenentladungsverdampfung wird mit hochenergetischen Ionen eine Übergangsschicht auf der Substratoberfläche erzeugt, welche eine gute Haftung der aufzubringenden Schicht auf dem Substrat gewährleistet, während bei der anschließenden Kathodenzerstäubung sowohl die Kondensationsgeschwindigkeit bei geringer Teilchenenergie in weiten Bereichen entsprechend dem gewünschten Kristallwachstum und Kristallgefüge der aufzubringenden Schicht als auch die Vorspannung am Substrat feinfühlig steuerbar ist, wobei auch aufgrund der geringen freien Weglänge der Bedampfungsteilchen die Schichtdickenverteilung auch um die Ecken herum gleichmäßig erfolgt.

Nachdem bei der Bogenentladungsverdampfung der Großteil der auf dem Substrat kondensierenden Teilchen ionisiert ist, läßt sich die kinetische Energie dieser ionenbildenden Teilchen beispielsweise mittels einer negativen Vorspannung am Substrat problemlos steuern. Mit der erfindungsgemäßen Kombination der Bogenentladungsverdampfung und der Kathodenzerstäubung werden demnach die durch die erzielbare gute Haftfestigkeit sowie die erzielbare gute Schichtqualität bestimmten Vorteile dieser beiden Beschichtungsverfahren in optimaler Weise ausgenutzt, ohne daß hierbei de eingangs genannten Nachteile in Kauf genommen werden müssen.

Vorzugsweise wird das Substrat während der Bogentladungsverdampfung zunächst mit Ionen derart optimierter hoher Energie und Ionenstromdichte beschossen, daß die Substratoberfläche durch Ionenätzung gereinigt und teilweise abgetragen wird. Die für diese Oberflächenreinigung erforderliche hohe Ionenenergie läßt sich beispielsweise durch eine entsprechend hohes, auf das Substrat gerichtetes elektrisches Feld, beispielsweise eine entsprechende negative Vorspannung des Substrats, problemlos erzielen, nachdem bei der Bogenentladungsverdampfung ein Großteil der auf das Substrat auftreffenden Teilchen ionisiert ist.

Biespielsweise durch eine entsprechende Wahl des auf das Substrat gerichteten elektrischen Feldes bzw. der negativen Vorspannung des Substrats kann der während der Bogenentladungsverdampfung erfolgende Ionenbeschuß des Substrats vorteilhafterweise stets auch mit derart optimierter hoher Ionenenergie und Ionenstromdichte durchgeführt werden, daß die gewünschte Verankerung der aufzubauenden Schicht im Substratmaterial bewirkt wird.

Hierzu wird der Ionenbeschuß des Substrats beispielsweise in der genannten Art und Weise vorzugsweise derart gesteuert, daß eine Ionenimplantation stattfindet, bei der die Ionen sowohl bis einige Atomnetzebenen tief in die Kristallite, und zwar in die Zwischenräume der Kristallatome, als auch zwischen die Kristallite eindringen, und daß zur Verankerung der aufzubauenden Schicht infolge örtlicher Erwärmung eine Interdiffusion von Atomen in den Substrat-Kristallgittern angeregt wird, welche feste Lösungen der eindringenden Atome in den Kristalliten, eine Mischkristallisation und beispielsweise bei Metallen auch intermetallische Verbindungen bewirkt. Damit ist es auf einfache Weise durch eine entsprechende Steuerung des Ionenbeschußes des Substrats möglich, eine optimale Haftung der aufzubauenden Schicht auf dem Substrat zu erzielen.

Nachdem auch die Verankerung der aufzubauenden Schicht im Substratmaterial bei höherer Ionenenergien stattfindet, können die Ionenätzung der Substratoberfläche sowie diese Verankerung der aufzubauenden Schicht vorteilhafterweise gleichzeitig erfolgen.

Gemäß einer bevorzugten Ausgestaltung des erfindungsgemäßen Verfahrens ist vorgesehen, die Bogenentladung zum Aufbau einer Haftgrenzschicht von einer die hohen Ionenenergien liefernden punktförmigen Entladung in einer ausgedehnte breitflä chige Entladung einer Kathodenzerstäubung zu überführnen. Dies kann beispielsweise durch ein langsames und kontinuierliches Verringern des auf das Substrat gerichteten elektrischen Feldes bzw. der negativen Substrat-Vorspannung erfolgen.

Die Bogenentladungsverdampfung wird zweckmäßigerweise kontinuierlich derart in die Kathodenzerstäubung überführt, daß während des Übergangs eine Überlagerung dieser beiden Beschichtungsarten stattfindet.

Ferner kann während im wesentlichen der gesamten die Verankerung der aufzubauenden Schicht bewirkenden Bogenentladungsverdampfung eine schwache Kathodenzerstäubung stattfinden, so daß insbesondere das Aufwachsen der Haftgrenzschicht kontinuierlich in die mittels der Kathodenzerstäubung hergestellte hochqualitative Schicht übergeht.

Währnd hierbei zur Erzeugung der Haftgrenzschicht insbesondere ein auf das Substrat gerichtetes elektrisches Feld langsam und kontinuierlich abgeschwächt wird, kann gleichzeitig die Kathodenzerstäubung insbesondere mittels einer Magnetronanordnung kontinuierlich verstärkt werden.

Um die gleichzeitige Durchführung sowohl der Bogenentladungsverdampfung als auch der Kathodenzerstäubung während des kontinuierlichen Übergangs von der einen zur anderen Beschichtungsmethode möglichst einfach zu gestalten, wird zur Erzeugung der Bogenentladungsverdampfung und der Kathodenzerstäubung vorteilhafterweise ein und dieselbe Kathode verwendet. Diese kann bei der Bogenentladungsverdampfung gleichzeitig eine Elektrode des Ionenstromkreises bilden, gegenüber der das Substrat bzw. ein Substrathalter negativ vorspannbar ist.

Generell kann das die Energie der auf dem Substrat auftreffenden Ionen bestimmende, auf das Substrat gerichtete elektrische Feld durch eine entsprechende Wahl dieses negativen Potentials des Substrats bzw. des Substrathalters gesteuert werden. Auf diese Weise ist es z.B. möglich, zumindest eine Elektrode, welche im genannten Fall die Anode bildet, für sämtliche Plasmastromkreise gemeinsam zu verwenden und auf dieser Elektrode ein gemeinsames Potential für diese Kreise zu schaffen.

Beim beschriebenen Verfahren wird das Substrat vorzugsweise in einer Kammer untergebracht, welche auf weniger als beispielsweise $1 \cdot 10^{-5}$ Torr ausgepumpt wird.

Die erfindungsgemäß Vorrichtung zur Durchführung des Verfahrens umfaßt eine das jeweilige Arbeitsgas aufnehmende Kammer, einen in der Kammer angeordneten Substrathalter sowie mehrere den Plasmastromkreisen für eine Bogenentladungsverdampfung bzw. eine Kathodenzerstäubung zugeordnete Elektroden und zeichnet sich dadurch aus, daß die durch einen Bogenstromkreis, einen Ionenstromkreis sowie den Plasmastromkreis für die Kathodenzerstäubung gebildeten Plasmastromkreise gegeneinander isoliert und unabhängig voneinander einstellbar sind, und daß der Bogenstromkreis und der Plasmastromkreis für die Kathodenzerstäubung eine gemeinsame Kathode aufweisen, welche zur Bildung eines gemeinsamen elektrischen Potentials für sämtliche Plasmastromkreise gleichzeitig eine Elektrode des Ionenstromkreises bildet, in dem der Substrathalter gegen diese gemeinsame Elektrode negativ schaltbar ist.

Dabei wird eine optimale und feinfühlige Steuerung der einzelnen Verfahrensabschnitte sowie der Übergänge von einem Verfahrensabschnitt in den anderen im wesentlichen dadurch ermöglicht, daß die einzelnen Plasmastromkreise voneinander isoliert sind und unabhängig voneinander auf die jeweils erforderlichen Werte eingestellt werden können und daß sie in einem Punkt, nämlich der Bogen- bzw. Zerstäubungskathode ein gemeinsames elektrisches Potential besitzen. Indem der Substrathalter im Ionenstromkreis gegenüber der gemeinsamen Elektrode, nämlich der Bogenkathode, negativ schalter ist, läßt sich zur Beeinflussung der Ionenenergie das betreffende, auf das Substrat gerichtete elektrische Feld erzeugen.

Für die Bogenentladung ist vorzugsweise eine besondere, vom Substrathalter getrennte Anode vorgesehen.

Das Gehäuse der Kammer ist zweckmäßigerweise geerdet. Im Plasmastromkreis für die Kathodenzerstäubung bildet diese vorzugsweise geerdete Kammergehäuse zweckmäßigerweise die Anode.

Weitere vorteilhafte Ausführungsvarianten der erfindungsgemäßen Vorrichtung sind in den Unteransprüchen angegeben.

Die Erfindung wird nachfolgend anhand eines Ausführungsbeispieles unter Bezugnahme auf die Zeichnung näher erläutert; in dieser zeigt:

Fig. 1 ein Diagramm der typischen Verteilung der kinetischen Energien der beim Beschichten eines Substrats mittels einer herkömmlichen Bogenentladungsverdampfung auf das Substrat auftreffenden Atome und Ionen (nach Maxwell),

Fig. 2 eine schematische Darstellung der erfindungsgemäßen Vorrichtung zur Beschichtung eines Substrates nach dem erfindungsgemäßen Verfahren, wobei die Vorrichtung zur Erläuterung der während der einzelnen Verfahrensabschnit te gegebenen Potentialverhältnisse dreifach dargestellt ist,

Fig. 3 eine schematische Darstellung der elektrischen Schaltung der in Fig. 2 dargestellten Vorrichtung,

Fig. 4 eine schematische Darstellung einer der Kathode zur Verstärkung der Kathodenzerstäubung zugeordneten, bezüglich der Kathodenplatte verschiebbaren Magnetronanordnung,

Fig. 5 eine teilweise geschnittene Draufsicht der das zur beschichtende Substrat aufnehmenden Kammer mit drei seitlich angeordneten Kathoden, und

Fig. 6 ein Diagramm zur Darstellung des zeitlichen Verlaufs des Bogenstroms sowie des Kathodenglimmstroms während einer jewieligen Substratbeschichtung.

Das Diagramm gemäß Fig. 1 zeigt die typische Verteilung der kinetischen Energien der auf ein zu beschichtendes Substrat auftretenden Atome und Ionen, wie sie sich bei einer Beschichtung mittels einer herkömmlichen Bogenentladungsverdampfung ergibt. Hierbei ist auf der Abszisse die kinetische Energie und auf der Ordinate die jeweilige Häufigkeit der eine betreffende kinetische Energie aufweisenden Teilchen aufgetragen.

Wie das Diagramm zeigt, treten beim herkömmlichen Bogenverdampfungsverfahren für die Kondensation auf dem Substrat Atome und Ionen mit einer sehr breiten Verteilung der kinetischen Energien oder Teilchen auf. Hierbei bewirken die hoch energetischen Teilchen mehr Zerstörung in der Art von Kristallzerspaltung, Kristallzerstörung oder einer Kathodenzerstäubung ähnlichem Verfall der Substratoberfläche als eine für ein fehlerfreises Kristallwachstum erforderliche gute, gleichmäßige Kondensation. Dieser Bereich der in erster Linie zu einer Zerstörung der Substratoberfläche führenden Energie liegt etwa oberhalb 200 eV.

Auf dem Substrat auftreffende Teilchen mit einer Energie von etwa 30 eV bis 200 eV ermöglichen beispielsweise bei gewissen Materialien ein Stengel- und Faserwachstum, was dem Aufbau einer hochqualitativen Schicht entgegensteht.

Lediglich die eine kinetische Energie von etwa 1 eV bis 30 eV besitzenden Teilchen führen zu einem optimalen Aufwachsen der auf das Substrat aufzubringenden Schicht. Bei einer solchen herkömmlichen Bogenentladungsverdampfung treffen ferner Teilchen mit einer kinetischen Energie unterhalb von etwa 1 eV auf, wleche für das erforderliche Kristallwachstum zu gering ist. Diese für einen ordnungsgemäßen Einbau in ein Kristallgitter eine zu geringe kinetische Energie aufweisenden Teilchen können demnach an unerwünschten Stellen kleben bleiben.

In den Fig. 2 und 3 ist die erfindungsgemäße Vorrichtung zur Beschichtung eines Substrats gemäß dem erfindungsgemäßen Verfahren schematisch wiedergegeben. In Fig. 2 ist die Vorrichtung zur Erläuterung der während der einzelnen Verfahrensabschnitte gegebenen Potentialverhältnisse dreifach dargestellt. Fig. 3 zeigt die elektrische Beschaltung der Vorrichtung.

Demnach umfaßt die erfindungsgemäße Vorrichtung eine das jeweilige Arbeitsgas aufnehmende Kammer 10, in welcher das be treffende Substrat 34 auf einem Substrathalter 12 angeordnet ist.

Die Vorrichtung weist ferner mehrere den Plasmastromkreisen für eine Bogenentladungsverdampfung sowie eine Kathodenzerstäubung zugeordnete Elektroden 10 bis 16 auf, welche zumindest teilweise innerhalb der Kammer 10 angeordnet bzw. durch das Kammergehäuse selbst gebildet sind.

Die Vorrichtung ist demnach zur Herstellung der aufzubringenden Schicht durch auf das betreffende Substrat auftreffende kondensierende Teilchen eines mittels einer Gasentladung erzeugten Plasmas ausgebildet. Hierbei wird, wie weiter unten noch im einzelnen zur erläutern ist, sowohl eine Bogenentladungsverdampfung als auch eine Kathodenzerstäubung vorgenommen, wobei die Bogenentladungsverdampfung vor der Kathodenzerstäubung durchgeführt wird.

Die Plasmastromkreise umfassen demnach einem Bogenstromkreis 18, eine Ionenstromkreis 20

sowie den Plasmastromkreis 22 für die Kathodenzerstäubung (vgl. Fig. 3).

Wie sich aus der in Fig. 3 wiedergegebenen Beschaltung der Anordnung ergibt, sind die verschiedenen Plasmastromkreise gegeneinander isoliert und unabhängig voneinander einstellbar.

Der Bogenstromkreis 18 für die Bogenentladungsverdampfung und der Plasmastromkreis 22 für die Kathodenzerstäubung weisen eine gemeinsame Kathode 14 auf. Diese Kathode 14 ist gleichzeitig die eine Elektrode im Ionenstromkreis 20, gegenüber der das Substrat 34 bzw. der Substrathalter 12 in diesem Ionenstromkreis 20 negativ schaltbar ist. Zur Verstärkung der kinetischen Energie der Ionen kann demnach zwischen der Elektrode 14 und dem Substrat 34 bzw. dem Substrathalter 12 ein zum Substrat hin gerichtetes elektrisches Feld erzeugt werden. Ferner haben sämtliche Plasmastromkreise 18 bis 22 in einem Punkt, nämlich der Elektrode 14, ein gemeinsames elektrisches Potential.

Das Gehäuse der Kammer 10 ist über eine Leitung 36 geerdet.

Die den Plasmastromkreisen 18 bis 22 gemeinsame Elektrode 14 weist bezüglich des Gehäuses der Kammer 10 ein hohes negatives Potential auf. Sie ist sowohl mit der negativen Klemme einer dem Bogenstromkreis 18 zugeordneten Spannungsquelle 24 als auch mit der negativen Klemme einer dem Plasmastromkreis 22 für die Kathodenzerstäubung zugeordneten Hochspannungsquelle 26 verbunden. Diese allen Plasmastromkreisen gemeinsame Elektrode 14 ist ferner an die positive Klemme einer dem Ionenstromkreis 20 zugeordneten Hochspannungsquelle 28 angeschlossen.

Die negative Klemme der dem Ionenstromkreis 20 zugeordneten Hochspannungsquelle 28 ist mit dem Substrathalter 12 verbindbar.

Hierbei ist der Substrathalter 12 mittels eines Umschalters 38 zwischen einer mit dem Gehäuse der Kammer 10 verbundenen bzw. geerdeten Klemme 30 und der negativen Klemme der dem Ionenstromkreis 20 zugeordneten Hochspannungsquelle 28 umschaltbar.

Im Plasmastromkreis 22 für die Kathodenzerstäubung bildet das geerdete Gehäuse der Kammer 10 eine Anode. Um während einer solchen Kathodenzerstäubung auch das Substrat 34 sowohl gegenüber der Kathode 14 als auch gegenüber der durch das Kammergehäuse gebildeten Anode positiv schalten zu können, ist der Substrathalter 12 wiederum mittels des Umschalters 38 ferner mit der positiven Klemme einer zusätzlichen Spannungsquelle 32 verbindbar, deren negative Klemme wiederum mit dem Gehäuse der Kammer 10 bzw. Erde verbunden ist. Die positive Klemme der den Bogenstromkreis 18 zugeordneten Hochspannungsquelle 24 ist mit der zwischen der Kathode 14 und dem Substrathalter 12 angeordneten Bogenanode verbunden. Diese Bogenanode 16 ist im vorliegenden Fall kegelstumpfförmig ausgebildet.

Zur Erzielung einer ausreichenden Hochspannungsisolation und zur Verhinderung ungewünschter Funken- und Bogenentladungen sind gemäß der Schaltung nach Fig. 3 insbesondere Hoch- und Niederfrequenzdrosseln vorgesehen. Es können unerwünschte Bogenströme von über 100 A auftreten. Derartige Schutzvorrichtungen sind erforderlich, da die Bogenkathode 14 auf einen Wert von -6000 V und der Substrathalter 12 auf eine Wert bis -8000 V gegenüber Erde vorgespannt sein können.

Fig. 4 zeigt eine schematische Darstellung einer der Kathode 14 zur Verstärkung der Kathodenzerstäubung zugeordneten Magnetronanordnung 40. Diese Magnetronanordnung 40 ist bezüblich der Kathode 14 verschiebbar und wird zur Verstärkung der Kathodenzerstäubung an die Rückseite der Kathodenplatte herangeschoben. Diese Magnetronanordnung 40 weist auf der der Kathode 14 zugewandten Seite abwechselnd unterschiedliche Pole auf. Sie kann mehrere ineinander angeordnete konzentrische Permanentmagnetringe umfassen. Im vorliegenden Fall sind beispielsweise zwei derartige Magnete sowie ein in der Mitte angeordneter Stabmagnet vorgesehen.

In Fig. 5 ist eine teilweise geschnittene Draufsicht auf die das Substrat 34 aufnehmende Kammer 10 gezeigt, in welcher drei jeweils um 120° gegeneinander versetzte Kathoden 14 angeordnet sind. Jeder Kathode 14 ist wiederum eine bezüglich dieser verschiebbare Magnetronanordnung 40 mit zumindest einem Permanentmagnetring zugeordnet. Außerhalb der Kam mer 10 und im Bereich der jeweiligen Kathode 14 ist eine Magnet-Spulenanordnung zur Erzeugung eines räumlich begrenzten, homogenen Magnetfelds vorgesehen. In dieser Figur 5 ist ebenso wie in der Fig. 2 (rechts) der während der Kathodenzerstäubung auftretende Dunkelraum 44 zwischen der jeweiligen Kathode 14 und der sich bildenden Glimmschicht 46 erkennbar.

Gemäß Fig. 5 umfaßt die Vorrichtung ferner eine isolierte Blende 48, welche das Substrat 34 auf dem hochspannungsisolierten, negativ vorgeschalteten Substrathalter 12 vor einer jeweiligen Bogenentladungsverdampfung zunächst schützt bzw. als Faraday-Auffänger für Ionen bei der Optimierung des Ionenstromes benutzt werden kann.

In Fig. 2 sind links die Potentialverhältnisse für den Bogenstromkreis, in der Mitte die Potentialverhältnisse für den Ionenstromkreis und rechts die Potentialverhältnisse für den Plasmastromkreis für die Kathodenzerstäubung dargestellt. Die Elektrode 14 bildet eine für sämtliche Plasmastromkreise gemeinsame Elektrode und dient im Bogenstromkreis sowie im Plasmastromkreis für die Kathodenzerstäubung jeweils als Kathode und im Ionenstromkreis als Anode. In allen Fällen liegt diese Elektrode 14 bezüglich dem geerdeten und damit auf 0-Potential liegenden Gehäuse der Kammer 10 auf einem hohen negativen Potential von -6000 V.

Im Bogenstromkreis (vgl. Fig. 2, links) ergeben sich die folgenden Potentialdifferenzen:
Bogenspannung etwa 50 bis 100 V, Potential der Bogenanode 16 gegen Erde -5950 V bis -5900 V, Potential der Bogenkathode 14 gegen Erde -6000 V.

Für den Plasmaionenstromkreis (vgl. Fig. 2, Mitte) ergeben sich die Potentialdifferenzen wie folgt:
Spannung für den Plasmaionenstrom etwa -50 V bis -2000 V, Potential des Substrathalters gegen Erde -6050 V bis -8000 V.

Im vorliegenden Fall weist die als Anode dienende Elektrode 14 ein Potential von -6000 V und der als Kathode dienende Substrathalter 12 für das Substrat 34 ein Potential von -8000 V auf.

Im Plasmastromkreis für die Kathodenzerstäubung (Fig. 2, rechts) ergibt sich zwischen der wiederum als Kathode dienenden Elektrode 14 und Erde bzw. dem als Anode dienenden Gehäuse der Kammer 10 eine Spannung von -6000 V. Der Substrathalter 12 für das Substrat 34 dient hierbei ebenfalls als Anode und ist beispielsweise auf 0 V bis +500 V vorspannbar.

Das Gehäuse der Kammer 10 ist jeweils geerdet und weist das Potential 0 V auf.

Zur Variation der jeweiligen Potentialdifferenzen sind die Spannungsquellen 24, 26, 28 und 32 (vgl. Fig. 3) zumindest teilweise auf verschiedene Spannungen einstellbar.

Im folgenden wird das mittels der beschriebenen Vorrichtung durchgeführte erfindungsgemäße Verfahren beschrieben. Dazu wird für die Beschichtung des Substrats 34 sowohl eine Bogenentladungsverdampfung als auch eine Kathodenzerstäubung vorgenommen, wobei die Bogenentladungsverdampfung vor der Kathodenzerstäubung durchgeführt wird.

Das Substrat 34 wird auf dem hochspannungsisolierten, negativ vorgeschalteten Substrathalter 12 zunächst durch die isolierte Blende 48 geschützt. Diese kann, wie bereits erwähnt, als Faraday-Auffänger für Ionen bei der Optimierung des Ionenstroms benutzt werden. Anschließüend wird die Vakuumkammer 10 entsprechend den Anforderungen des Verfahrens auf beispielsweise weniger als 1 • $10^{-5}$ Torr ausgepumpt. Danach werden die Hochspannungen langsam auf ihre optimierten Werte an der für die Bogenentladungsverdampfung als Kathode dienenden Elektrode 14, der Bogenanode 16 sowie am Substrathalter 12 gebracht.

Die Elektrode 14 wird demnach bei zurückgezogener Magnetronanordnung zunächst als Bogenkathode benutzt. Der Bogen wird bei geschlossener Blende 48 (Shutter) gezündet, worauf dessen Betriebsbedingungen zusammen mit den Betriebsgasen optimiert werden (beispielsweise 5 • $10^{-3}$ Torr bis 1 • $10^{-2}$ Torr Betreibsgas).

Der Ionenstromkreis wird daraufhin für eine Ionenätzung der Substratsoberfläche bei einer Hochspannung von -1000 V bis -2000 V, d.h. bei einem Substratpotential von -7000 V bis -8000 V bezüglich des geerdeten Gehäuses der Kammer 10 eingestellt (vgl. Fig. 2, mitte). Diese Ionenätzung (Sputter cleaning) beginnt mit dem Öffnen der Blende 48 (vgl. Fig. 5).

Wie dem Diagramm zur Darstellung des zeitlichen Verlaufs des Bogenstromes sowie des Kathodenglimmstromes gemäß Fig. 6 entnommen werden kann, wird hierzu der Bogenstrom zunächst nach der Zündung auf einen Stromwert $I_1$ gebracht, wobei nach Erreichen dieses Zwischenstromwertes $I_1$ die Blende zur Ionenätzung geöffnet wird. Die Ionenätzung wird beispielsweise 30 bis 60 Sekunden bei einer Ionenstromdichte von etwa 0,5 mA/cm$^2$ oder geringer und einer Beschleunigungsspannung von etwa -1500 V bis -2000 V durchgeführt. Hier kann bei stark erhöhter negativer Vorspannung auch eine kurzzeitige Ionenimplantation vorgenommen werden (vgl. weiter unten).

Anschließend wird die negative Substratspannung langsam und kontinuierlich verringert, so daß die Ionen die Substratoberfläche nicht mehr abtragen bzw. abätzen, sondern zur Bildung einer Haftgrenzschicht kondensieren. Hierbei erreicht der Bogenstrom einen oberhalb vom Wert $I_1$ liegenden Stromwert $I_2$.

Während dieses Vorganges wird eine leichte und langsame Kathodenzerstäubung erzeugt, bei welcher sich ein Kathodenglimmstrom mit einem geringen Wert $I_3$ einstellt. Diese wird anschließend kontinuierlich durch ein langsames Heranschieben der Magnetronanordnung an die Rückseite der Kathodenplatte verstärkt, bis der Kathodenglimmstrom vom niedrigeren Wert $I_3$ auf den höheren Stromwert $I_4$ angestiegen ist (vgl. Fig. 6). Gleichzeitig wird der Bogenstrom vom Wert $I_2$ ausgehend verringert, bis der Bogen erlischt und der Bogenstrom 0 A beträgt. Für die sich anschließende Kathodenzerstäubung wird gleichzeitig die Vorspannung der Substrathalterung 12 auf den gewünschten Wert, beispielsweise auf einen Wert zwischen 0 V und +500 V, gebracht.

Durch die erfindungsgemäße Vorrichtung können die einzelnen Verfahrensschritte wie die Oberflächenreinigung mittels einer Ionenätzung, danach der Aufbau einer gut haftenden Grenzschicht und schließlich der Aufbau der gewünschten hochqualitativen Schicht mittels der Kathodenzerstäubung kontinuierlich ohne Unterbrechung in derselben Vakuumanlage und an derselben Stelle durchgeführt werden.

Gleichzeitig mit dem Ionenbeschuß des Substrats mit Ionen einer die Ionenätzung bewirkenden optimierten hohen Energie und Ionenstromdichte wird auch die erwünschte fest Verankerung der aufzubauenden Schicht im Substratmaterial bewirkt. Für den vorgenommenen Ionenbeschuß wird nämlich die Ionenenergie und -stromdichte gleichzeitig derart gewählt, daß eine Art Ionenimplantation stattfindet, bei der die Ionen so wohl bis einige Atomnetzebenen tief in die Kristallite, und zwar in die Zwischenräume der Kristallatome, als auch zwischen die Kristallite eindringen und daß zur Verankerung der durch die anschließende Kathodenzerstäubung aufzubringende Schicht infolge örtlicher Erwärmung eine Interdiffusion von Atomen in den Substrat-Kristallgittern angeregt wird, welche feste Lösungen der eindringenden Atome in den Kristalliten, eine Mischkristallisation und beispielsweise bei Metallen auch intermetallische Verbindungen bewirkt.

Hierbei wird zunächst eine Haftgrenzschicht erzeugt, indem die Bogenentladung von einer die hohen Ionenenergien liefernden punktförmigen Entladung in einen ausgedehnte breitflächige Entladung überführt wird. Hierzu dient das bereits erwähnte langsame und kontinuierliche Verringern der negativen Substratspannung, wodurch in kontinuierlichem Übergang die Grenzschicht entstehen kann.

Wie aus Fig. 6 deutlich hervorgeht, findet während der kontinuierlichen Überführung der Bogenentladungsverdampfung in die Kathodenzerstäubung eine Überlagerung dieser beiden Beschichtungsverfahren statt. Hierbei wird die breitflächige Bodenentladung für den Haftgrenzschichtaufbau kontinuierlich in die Kathodenzerstäubung überführt.

Die während der Verankerung der aufzubauenden Schicht mittels der Bogenentladungsverdampfung gleichzeitig durchgeführte schwache Kathodenzerstäubung dient dazu, sicherzustellen, daß das Aufwachsen der Haftgrenzschicht kontinuierlich in die gewünschte, mittels der Kathodenzerstäubung hergestellte hochqualitative Schicht übergeht, wobei hierzu während des Aufbaus der Grenzschicht die Kathodenzerstäubung zusätzlich mittels des Magnetroneffekts verstärkt wird. Die in der mittels der Bogenentladungsverdampfung hergestellten Verankerungsschicht evtl. enthaltenen Tröpfchen und Makropartikel werden durch die darüberliegende Haftgrenzschicht sowie die mittels der Kathodenzerstäubung aufgebrachte hochqualitative Schicht überdeckt. Grundsätzlich kann jedoch auch eine derartige Steuerung der Bogenentladung während der Bogenentladungsverdampfung vorgenommen werden, daß das Entstehen derartiger Makropartikel vollständig ausgeschlossen ist (vgl. z.B. WO-A-8 503 954, 0 283 095 A1).

Das erfindungsgemäße Verfahren weist demnach die wesentlichen Vorteile der Bogenentladungsverdampfung sowie der Kathodenzerstäubung, nämlich eine besonders gute Haftfestigkeit sowie eine außerordentlich hohe Schichtqualität, auf, ohne die bei diesen Verfahren bisher auftretenden Nachteile in Kauf nehmen zu müssen.

Erfindungsgemäß wird nämlich der Umstand ausgenutzt, daß bei der Bogenentladungsverdampfung der Großteil der auf dem Substrat kondensierenden Teilchen ionisiert ist und die kinetische Energie dieser Ionen beispielsweise mittels einer negativen Vorspannung des Substrats problemlos gesteuert werden kann. Damit ist auf einfache Weise die Möglichkeit geschaffen, mit hochenergetischen Ionen eine Übergangsschicht auf der Substratoberfläche zu erzeugen, wobei durch eine Art Ionenimplantation, Interdiffusion und Mischkristallbildung die Haftung der aufzubringenden Schicht verbessert werden kann. Schließlich wird beim Aufbringen der oberen hochqualitativen Schicht der Umstand ausgenutzt, daß bei einer Kathodenzerstäubung die Kondensationsgeschwindigkeit bei geringer Teilchenenergie in weiten Bereichen zur Erzielung des jeweils gewünschten Kristallwachstums und Kristallgefüges steuerbar ist und andererseits aufgrund der geringen freien Weglänge der Bedampfungsteilchen die Schichtdickenverteilung auch um die Ecken herum außerordentlich gleichmäßig erfolgt.

## Ansprüche

1. Verfahren zur Beschichtung von Substraten, bei welchem die aufzubringende Schicht durch auf das betreffende Substrat auftreffende kondensierende Teilchen eines mittels einer Gasentladung erzeugten Plasmas hergestellt wird,
dadurch **gekennzeichnet,**
daß sowohl eine Bogenentladungsverdampfung als auch eine Kathodenzerstäubung vorgenommen wird und daß die Bogenentladungsverdampfung vor der Kathodenzerstäubung durchgeführt wird.

2. Verfahren nach Anspruch 1,
dadurch **gekennzeichnet,**
daß das Substrat während der Bogenentladungsverdampfung zunächst mit Ionen derart optimierter hoher Energie und Ionenstromdichte beschossen wird, daß die Substratoberfläche durch Ionenätzung gereingt und teilweise abgetragen wird.

3. Verfahren nach Anspruch 1 oder 2,
dadurch **gekennzeichnet,**
daß der während der Bogenentladungsverdampfung erfolgende Ionenbeschuß des Substrats mit derart optimierter hoher Ionenenergie und -stromdichte durchgeführt wird, daß eine Verankerung der aufzubauenden Schicht im Substratmaterial bewirkt wird.

4. Verfahren nach Anspruch 3,
dadurch **gekennzeichnet,**
daß der Ionenbeschuß des Substrats durch entsprechend optimierte Ionenenergie und -stromdichte derart durchgeführt wird, daß eine Ionenimplantation stattfindet, bei der die Ionen sowohl bis einige Atomnetzebenen tief in die Kristallite, und zwar in die Zwischenräume der Kristallatome, als auch zwischen die kristallite eindringen, und daß zur Verankerung der aufzubauenden Schicht infolge örtlicher Erwärmung eine Interdiffusion von Atomen in den Substrat-Kristallgittern angeregt wird, welche feste Lösungen der eindringenden Atome in den Kristalliten, eine Mischkristallisation und beispielsweise bei Metallen auch intermetallische Verbindungen bewirkt.

5. Verfahren nach einem der vorhergehenden Ansprüche,
dadurch **gekennzeichnet,**
daß die Ionenätzung der Substratoberfläche sowie die Verankerung der aufzubauenden Schicht im Substratmaterial gleichzeitig erfolgen.

6. Verfahren nach einem der vorhergehenden Ansprüche,
dadurch **gekennzeichnet,**
daß die Bogenentladung zum Aufbau einer Haftgrenzschicht von einer die hohen Ionenenergien liefernden punktförmigen Entladung in eine ausgedehnte breitflächige Entladung überführt wird.

7. Verfahren nach einem der vorhergehenden Ansprüche,
dadurch **gekennzeichnet,**
daß die Bogenentladungsverdampfung kontinuierlich derart in die Kathodenzerstäubung überführt wird, daß während des Übergangs eine Überlagerung dieser beiden Beschichtungsarten stattfindet.

8. Verfahren nach Anspruch 6 und 7,
dadurch **gekennzeichnet,**
daß die breitflächige Bogenentladung kontinuierlich in die Kathodenzerstäubung überführt wird.

9. Verfahren nach einem der vorhergehenden Ansprüche,
dadurch **gekennzeichnet,**
daß während der gesamten, die Verankerung der aufzubauenden Schicht bewirkenden Bogenentladungsverdampfung eine schwache Kathodenzerstäubung durchgeführt wird.

10. Verfahren nach einem der vorhergehenden Ansprüche,
dadurch **gekennzeichnet,**
daß zur Erzeugung der Haftgrenzschicht ein auf das Substrat gerichtetes elektrisches Feld langsam und kontinuierlich abgeschwächt wird und daß gleichzeitig die Kathodenzerstäubung insbesondere mittels einer Magnetronanordnung kontinuierlich verstärkt wird.

11. Verfahren nach einem der vorhergehenden Ansprüche,
dadurch **gekennzeichnet,**
daß zur Erzeugung der Bogenentladungsverdampfung und der Kathodenzerstäubung ein und dieselbe Kathode verwendet wird.

12. Verfahren nach einem der vorhergehenden Ansprüche,
dadurch **gekennzeichnet,**
daß das die Energie der auf dem Substrat auftreffenden Ionen bestimmende, auf das Substrat gerichtete elektrische Feld durch eine entsprechende Wahl des negativen Potentials des Substrats bzw. eines Substrathalters gesteuert wird.

13. Vorrichtung zur Durchführung des Verfahrens nach einem der vorhergehenden Ansprüche, mit einer das jeweilige Ar beitsgas aufnehmenden Kammer (10), einem in der Kammer angeordneten Substrathalter (12) sowie mehreren den Plasmastromkreisen für eine Bogenentladungsverdampfung bzw. eine Kathodenzerstäubung zugeordneten Elektroden (10 bis 16),
dadurch **gekennzeichnet,**
daß die durch einen Bogenstromkreis (18), eine Ionenstromkreis (20) sowie den Plasmastromkreis (22) für die Kathodenzerstäubung gebildeten Plasmastromkreise gegeneinander isoliert und unabhängig voneinander einstellbar sind, und daß der Bogenstromkreis (18) und der Plasmastromkreis (22) für die Kathodenzerstäubung eine gemeinsame Kathode (14) aufweisen, welche zur Bildung eines gemeinsamen elektrischen Potentials für sämtliche Plasmastromkreise (18 bis 22) gleichzeitig eine Elektrode des Ionenstromkreises (20) bildet, in dem der Substrathalter (12) gegen diese gemeinsame Elektrode negativ schaltbar ist.

14. Vorrichtung nach Anspruch 13,
dadurch **gekennzeichnet,**
daß das Gehäuse der Kammer (10) geerdet ist.

15. Vorrichtung nach Anspruch 13 oder 14,
dadurch **gekennzeichnet,**
daß das Gehäuse der Kammer (10) im Plasmastromkreis (22) für die Kathodenzerstäubung eine Anode bildet.

16. Vorrichtung nach einem der Ansprüche 13 bis 15,
dadurch **gekennzeichnet,**
daß die den Plasmastromkreisen (18 bis 22) gemeinsame, bezüglich des Gehäuses der Kammer (10) ein hohes negatives Potential aufweisende Elektrode (14) sowohl mit den negativen Klemmen der dem Bogenstromkreis (18) und dem Plasmastromkreis (22) für die Kathodenzerstäubung zuge ordneten Hochspannungsquelle (26), der Niederspannungsquelle (24) und der positiven Klemme der dem Ionenstromkreis (20) zugeordneten Hochspannungsquelle (28) verbunden ist, während die negative Klemme der dem Ionenstromkreis (20) zugeordneten Hochspannungsquelle (28) mit dem Substrathalter (12) verbindbar ist.

17. Vorrichtung nach einem der Ansprüche 13 bis 16,
dadurch **gekennzeichnet,**
daß der Substrathalter (12) für die Kathodenzerstäubung auf das gleiche Potential wie das Gehäuse der Kammer (10) oder bezüglich diesem positiv schaltbar ist.

18. Vorrichtung nach einem der Ansprüche 13 bis 17,
dadurch **gekennzeichnet,**
daß der Substrathalter (12) zwischen einer mit dem Gehäuse der Kammer (10) verbundenen, insbesondere geerdeten Klemme (30), der positiven Klemme einer zusätzlichen Spannungsquelle (32), deren negative Klemme insbesondere mit dem Kammergehäuse verbunden ist, und der negativen Klemme der dem Ionenstromkreis (20) zugeordneten Hochspannungsquelle (28) umschaltbar ist.

FIG. 1

Typische Maxwell-Energieverteilung

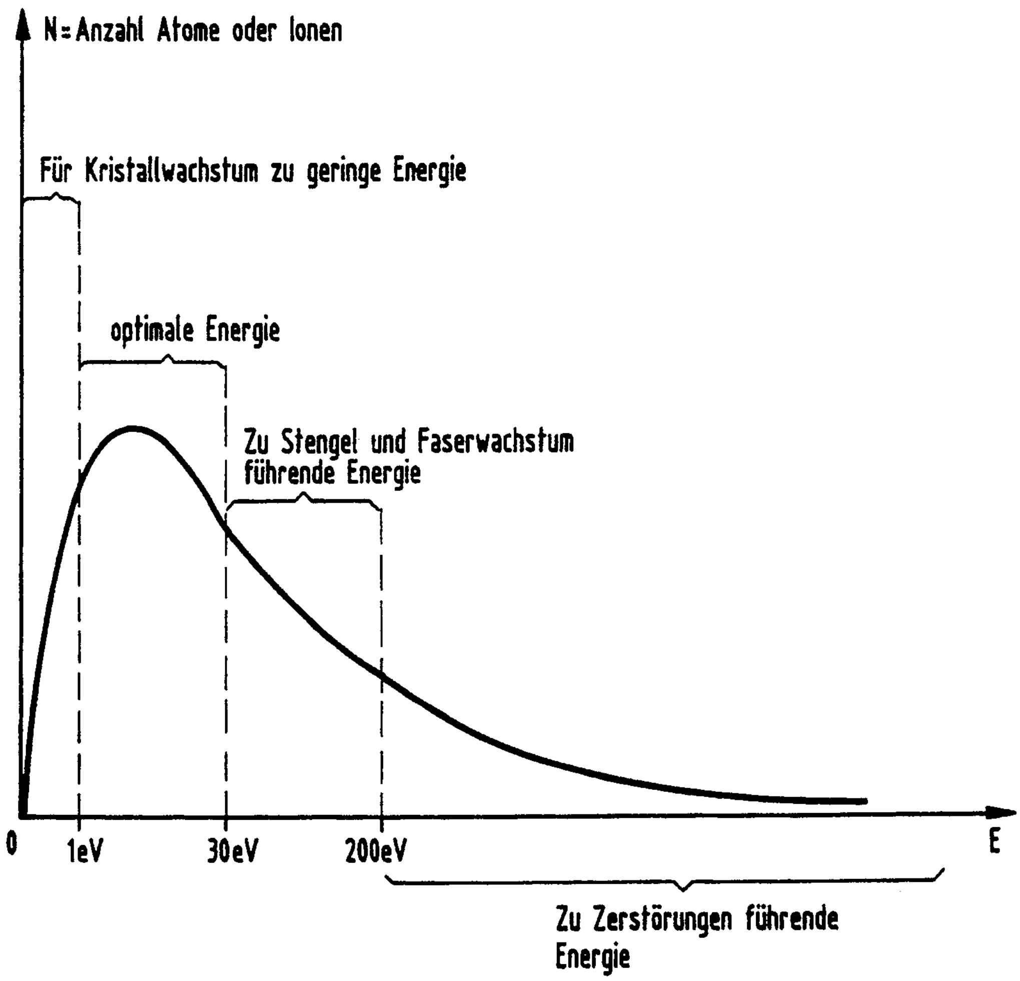

FIG. 2

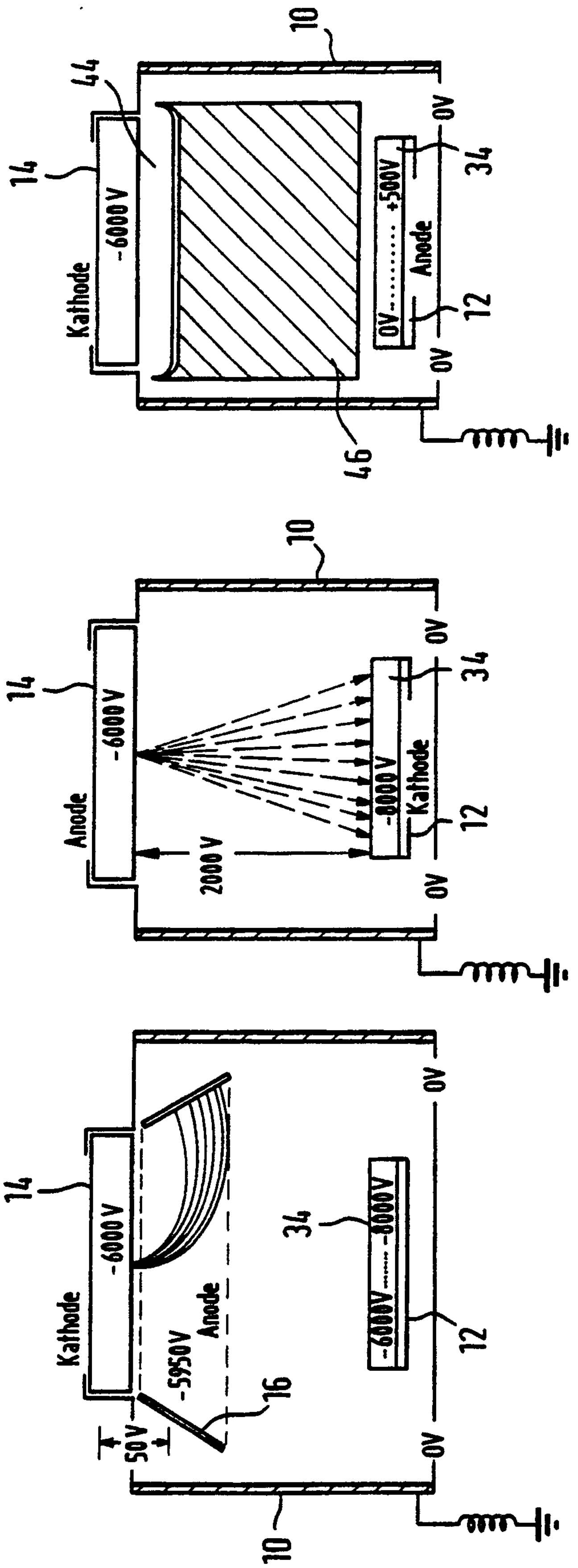
14
Kathode
-6000V
44
10
0V
0V ........ +500V
Anode
34
12
46
14
Anode
-6000V
2000V
-8000V
Kathode
34
12
0V
0V
10
14
Kathode
-6000V
-5950V
Anode
50V
16
34
-6000V ........ -8000V
12
0V
0V
10

FIG. 3

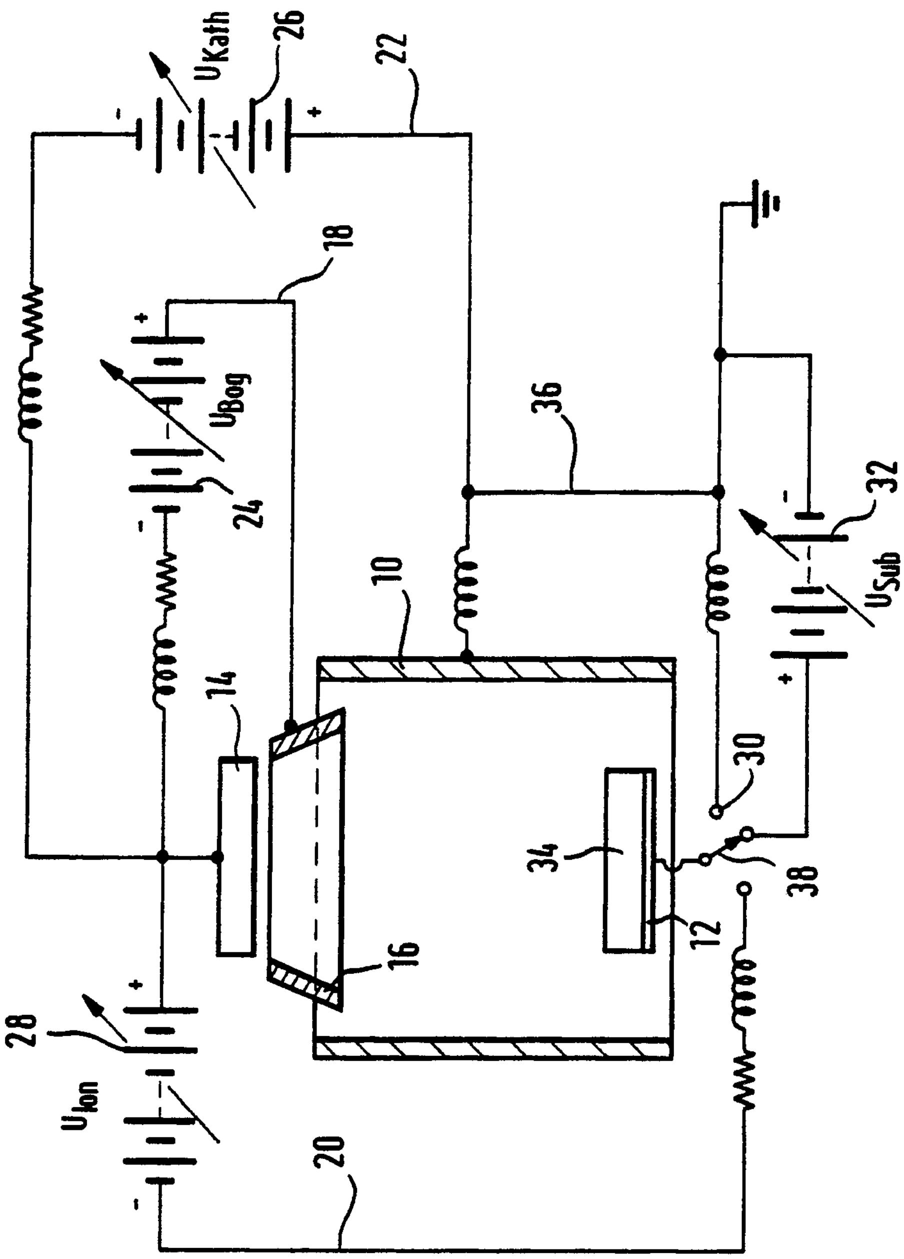

FIG.4

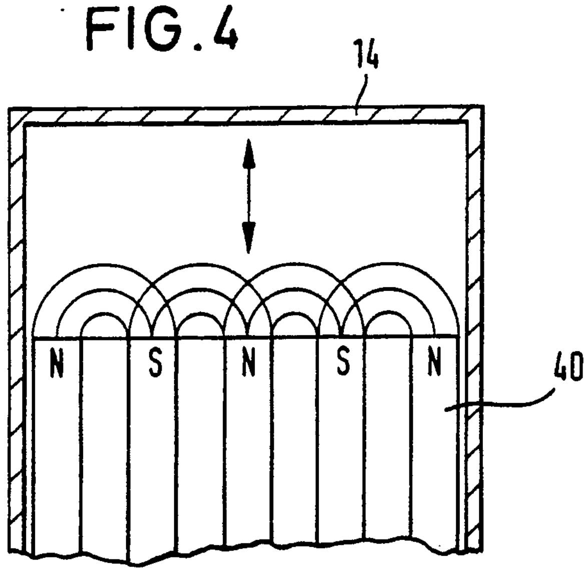


FIG.5

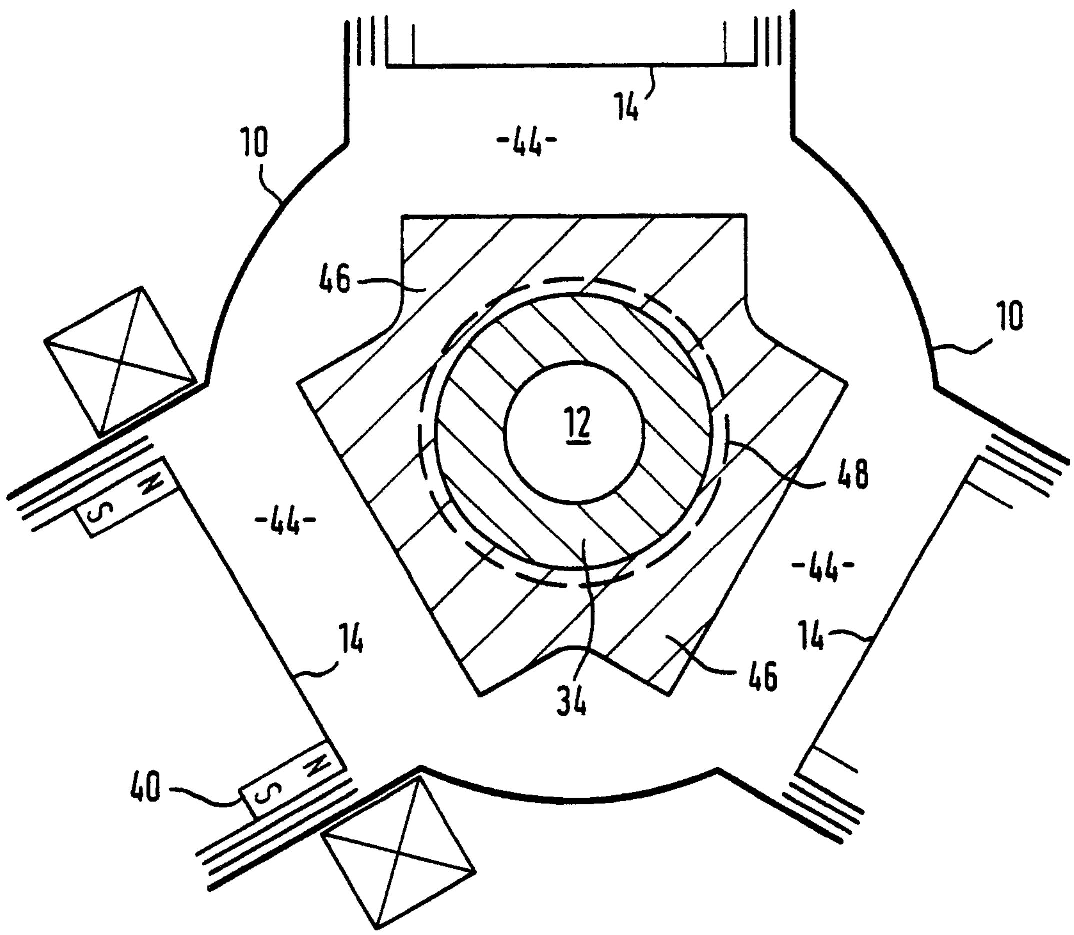

FIG. 6

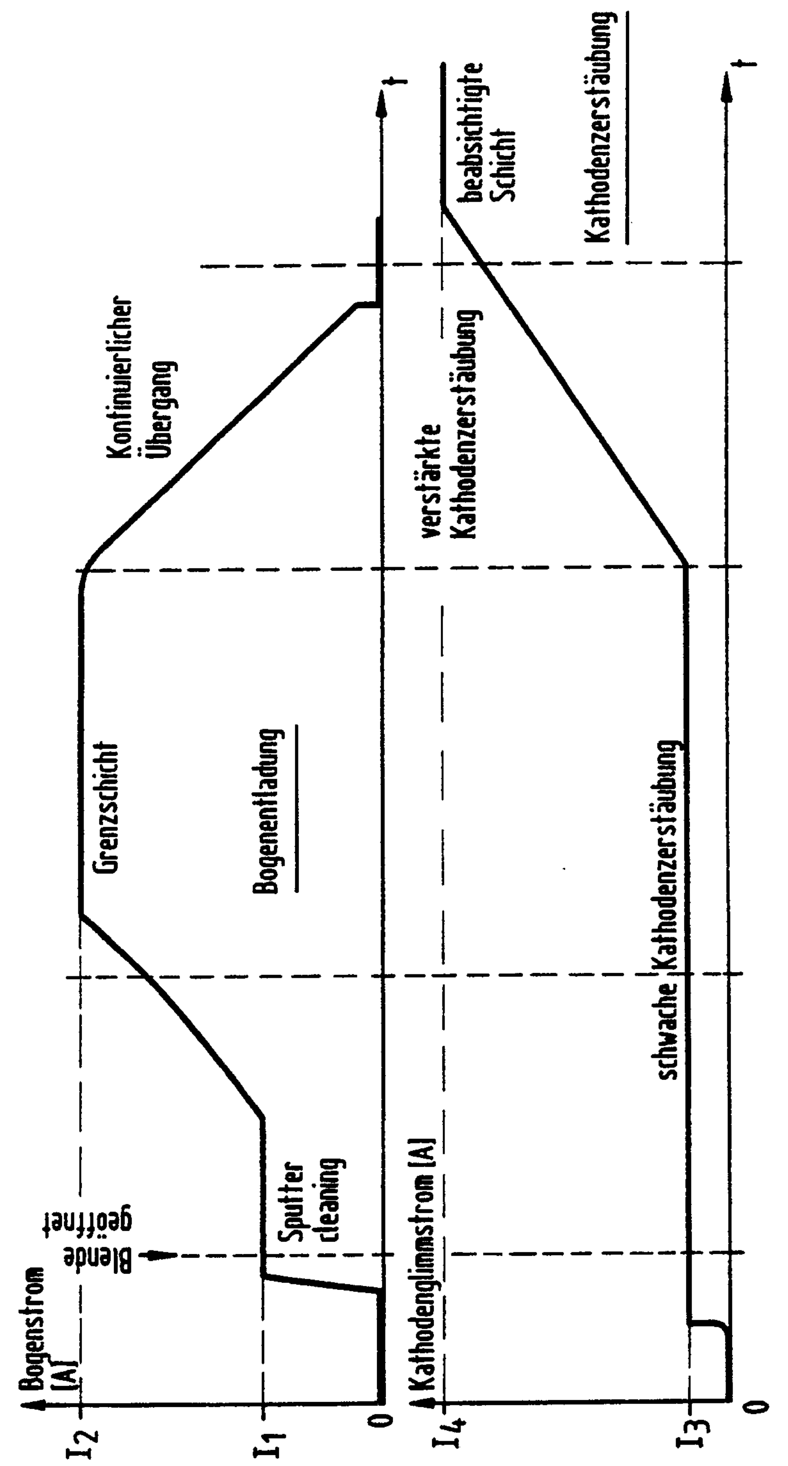
Bogenstrom [A]
Blende geöffnet
Sputter cleaning
Grenzschicht
Bogenentladung
Kontinuierlicher Übergang
t
$I_2$
$I_1$
0
Kathodenglimmstrom [A]
$I_4$
$I_3$
0
schwache Kathodenzerstäubung
verstärkte Kathodenzerstäubung
beabsichtigte Schicht
Kathodenzerstäubung
t

Europäisches Patentamt

# EUROPÄISCHER RECHERCHENBERICHT

Nummer der Anmeldung

EP 89 11 1705

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-1 521 262 (GENERAL ELECTRIC CO.)<br>* Seite 4, Zeilen 12-18; Seite 5, Zeile 5 - Seite 6, Zeile 18; Seite 13, Zeile 18 - Seite 15, Zeile 17; Figur 1 * | 1-8,11, 13,14 | C 23 C 14/02<br>C 23 C 14/42 |
| A | DD-A- 246 571 (VEB HOCHVAKUUM DRESDEN)<br>* Zusammenfassung; Seite 2, Zeile 53 - Seite 3, Zeile 11; Fig. * | 1-8,13 | |
| A | JOURNAL OF VACUUM SCIENCE & TECHNOLOGY/PART A, Band 5, Nr. 2, März/April 1987, Seite 196, Woodbury, US; U.K. CHAKRABARTI et al.: "Deposition of zirconium boride thin films by direct current triode sputtering"<br>* Seite 196, Zeile 1, Absatz II,A; Seite 197, Zeile 1; Figur 1, Absatz II, B * | 1 | |
| | | | RECHERCHIERTE SACHGEBIETE (Int. Cl.5) |
| A | LE VIDE/LES COUCHES MINCES, Band 44, Nr. 245, Januar/Februar 1989, Seite 45, Paris, FR; L.A. STELMACK: "Ion-beam assisted deposition of optical coatings"<br>* Seite 45, Absatz 3 * | 1 | C 23 C |
| A | GB-A-2 155 044 (VSEZOJUZNY NAUCHNO-ISSLEDOVATELSKY INSTRUMENTALNY INSTITUT) | | |
| A | TRANSACTIONS OF THE INSTITUTE OF METAL FINISHING, Band 64, Nr. 4, November 1986, Seite 15, London, GB: "Ion assisted coatings - A new research project at Harwell" | | |

Der vorliegende Recherchenbericht wurde für alle Patentansprüche erstellt

| Recherchenort | Abschlußdatum der Recherche | Prüfer |
|---|---|---|
| DEN HAAG | 28-02-1990 | JOFFREAU P.O. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)